# EUROPEAN PATENT APPLICATION

(11) **EP 2 421 060 A1**
(43) Date of publication of application: **22.02.2012**
(21) Application number: 10764414.8
(22) Date of filing: 12.04.2010
(51) Int. Cl.: H01L 33/48

(54) **LIGHT-EMITTING DIODE**

(30) Priority: 13.04.2009 JP 2009097265
(71) Applicant: Panasonic Electric Works Co., Ltd., Kadoma-shi Osaka 571-8686 (JP)
(72) Inventor: URANO, Youji, Kadoma-shi Osaka 571-8686 (JP)
(74) Representative: Buchetmann, Dominik
(86) International application number: PCT/JP2010/056511
(87) International publication number: WO 2010/119830

(57) **Abstract**

A light emitting diode comprises a LED chip, a package in which the LED chip is housed, and a connection electrode electrically connected to an element electrode with which the LED chip is provided. The package is a laminated body comprising at least a submount substrate and a frame body, and the LED chip is fixedly-mounted on one surface of the submount substrate, and the frame body is laminated on the one surface of the submount substrate and is provided with a through-hole in which the LED chip is stored. The connection electrode is formed on at least either the one surface of the submount substrate or one surface of the frame body facing toward a light irradiation direction, while being exposed in the light irradiation direction. Therefore, the light emitting diode can improve both heat dissipation performance and density of LED placement together.

## Description

### TECHNICAL FIELD

The invention relates generally to light emitting diodes and, more particularly, to a light emitting diode comprising a light emitting diode chip having high brightness and a package in which the light emitting diode chip is housed.

### BACKGROUND ART

In the past, there have been proposed various light emitting diodes, comprising light emitting diode chips (LED chips) having high brightness, packages in which the LED chips are housed, and connection electrodes electrically connected to element electrodes with which the LED chips are provided. Then, most of the packages are cannon-ball type packages or surface-mount type packages. An example of the cannon-ball type packages is described in Japanese Patent Application Laid-Open No. 2006-140407 published on June 1, 2006. Then, an example of the surface-mount type packages is described in Japanese Patent Application Laid-Open No. 2007-12727 published on January 18, 2007.

A connection electrode in a cannon-ball type package is formed into a linear shape, and projects from one surface of the package into the outside. Then, a connection electrode in a surface-mount type package is formed into a sheet, and projects from a periphery of the package into the outside. In addition, in both configurations, the LED chip housed in the package is sealed with a synthetic resin molding product or by potting a synthetic resin, and thereby is protected.

By the way, in the cannon-ball type package, the connection electrode is located so as to project from one surface of the package, facing toward a direction opposite to a light irradiation direction. Thereby, high-density of LED placement can be achieved when a plurality of packages are arranged. However, it is difficult to secure a heat dissipation member to this kind of light emitting diode. Thus, there is a problem not to be able to ensure heat dissipation performance.

On the other hand, in the surface-mount type package, it is easy to secure the heat dissipation member to one surface of the package, facing toward a direction opposite to a light irradiation direction, and thus the heat dissipation performance can be ensured. However, the connection electrode is located so as to project from a periphery of the package. Thus, there is a problem not to be able to achieve high-density of LED placement when a plurality of packages are arranged.

That is, the conventional light emitting diodes have a problem that it is difficult to improve both heat dissipation performance and density of LED placement together.

### DISCLOSURE OF THE INVENTION

It is an object of the present invention to provide a light emitting diode, which can improve both heat dissipation performance and density of LED placement together.

A light emitting diode of the present invention comprises a LED chip, a package in which the LED chip is housed, and a connection electrode electrically connected to an element electrode with which the LED chip is provided. The package is a laminated body comprising at least a submount substrate and a frame body. The LED chip is fixedly-mounted on one surface of the submount substrate. The frame body is laminated on the one surface of the submount substrate, and is provided with a through-hole in which the LED chip is stored. According to a first aspect of the present invention, the connection electrode is formed on at least either the one surface of the submount substrate or one surface of the frame body facing toward a light irradiation direction, while being exposed in the light irradiation direction. In this configuration, because the connection electrode is formed on at least either the one surface of submount substrate or one surface of the frame body facing toward a light irradiation direction, while being exposed in the light irradiation direction, the light emitting diode can be formed so that the connection electrode does not project from a periphery of the package or a rear surface of the package facing toward a direction opposite to the light irradiation direction. Therefore, one can easily secure the heat dissipation member to the rear surface of the package facing toward a direction opposite to a light irradiation direction. In particular, the LED chip is fixedly-mounted on the one surface of the submount substrate, and thus the light emitting diode can radiate heat more effectively by securing the heat dissipation member to the rear surface of the package, as described above. Then, when a plurality of packages are arranged and constitute one light source, adjacent packages can be closely located each other. That is, density of LED placement can be improved. Therefore, the light emitting diode can improve both heat dissipation performance and density of LED placement together.

In an embodiment, an inner periphery face of the through-hole is formed so that a diameter thereof gradually increases toward the light irradiation direction from the submount substrate. The through-hole is provided with a conductive connecting pattern electrically connected to the connection electrode on the inner periphery face. The connecting pattern is electrically connected to the element electrode of the LED chip. In this configuration, an inner periphery face of the through-hole is formed so that a diameter thereof gradually increases toward the light irradiation direction from the submount substrate. Therefore, one can easily perform connection work to electrically connect the element electrode with the connection electrode, even if a storage space for the LED chip, surrounded by the inner periphery face of the through-hole, is relatively small.

In an embodiment, the connection electrode comprises a first connection electrode and a second connection electrode. The first connection electrode is formed on the one surface of the submount substrate, and the second connection electrode is formed on the one surface of the frame body facing toward the light irradiation direction. The first and second connection electrodes are electrically insulated from each other. In this configuration, because the first connection electrode is formed on the one surface of the submount substrate, and the second connection electrode is formed on the one surface of the frame body facing toward the light irradiation direction, the first and second connection electrodes can be located so as to have a difference in height each other. Therefore, it becomes easy to distinguish the polarity of these electrodes.

In an embodiment, the package is formed into a rectangular shape as viewed from the light irradiation direction. The frame body is provided with a first electrode window, and then the first electrode window exposes the first connection electrode located in each of two corner portions on the one surface of the submount substrate. The frame body is provided with the second connection electrode in each of the remaining two corner portions. In this configuration, because the package is formed into a rectangular shape as viewed from the light irradiation direction and the first connection electrode is exposed by the first electrode window formed in each of the two corner portions of the frame body and the frame body is provided with the second connection electrode in each of the remaining two corner portions, a whole of the package can be formed into a rectangular solid. Thus, when a plurality of packages are arranged, the density of LED placement can be improved more. Then, if the connection electrodes having one polarity are located in adjacent two corner portions of four corner portions in the package and the connection electrodes having the other polarity are located in the remaining adjacent two corner portions and a direction of the package is adjusted, one can easily perform connection work to electrically connect a plurality of packages together.

According to a second aspect of the present invention, the frame body is formed by lamination of a plurality of frame boards. Then, one frame board of the plurality of frame boards comprises a connection piece projecting into the through-hole, and the one frame board is something other than a frame board laminated at the outmost edge in the light irradiation direction. The connecting pattern is located on one surface of the connection piece facing toward the light irradiation direction. In this configuration, because the connecting pattern is located on one surface of the connection piece facing toward the light irradiation direction, the connecting pattern's size can be ensured easily even if the package's size is reduced. Therefore, one can easily perform connection work to connect the LED chip with the connecting pattern.

According to a third aspect of the present invention, the package comprises a window cover. The window cover is laminated on the submount substrate via the frame body, and is transparent to light radiated from the LED chip. In this configuration, because the package comprises the window cover, the package can protect the LED chip from environment, and thus the LED chip can have a long life.

In an embodiment, the submount substrate, the frame body, and the window cover are secured together so that an inside of the through-hole is airproofed. In this configuration, the submount substrate, the frame body, and the window cover are secured together so that an inside of the through-hole is airproofed, the package can protect the LED chip from environment, and attenuation of light intensity can be inhibited compared with potting of a synthetic resin, and luminous efficiency can be increased. In addition, although it depends on a selected material, the window cover has a wide choice of material compared with the synthetic resin used for potting. Thus, if a material with highly-heat and light resistance is selected for the window cover, the light emitting diode can have a longer life.

In an embodiment, the connection electrode comprises a first connection electrode and a second connection electrode, and the first connection electrode is formed on the one surface of the submount substrate, the second connection electrode is formed on the one surface of the frame body facing toward the light irradiation direction. The first and second connection electrodes are electrically insulated from each other. The package is formed into a rectangular shape as viewed from the light irradiation direction. The frame body is provided with a first electrode window, and the first electrode window exposes the first connection electrode located in each of two corner portions on the one surface of the submount substrate. The window cover is provided with a second electrode window, and the second electrode window exposes the first electrode window and the second connection electrode located in each of the remaining two corner portions of the frame body. In this configuration, because the package is formed into a rectangular shape as viewed from the light irradiation direction and the first connection electrode is exposed by the first electrode window formed in each of two corner portions of the frame body and further the first and second connection electrodes are exposed by four second electrode windows formed in four corner portions of the window cover, the package can protect the LED chip from environment and luminous efficiency can be increased and one can easily perform connection work to electrically connect a plurality of packages together.

In an embodiment, the window cover is provided with a microstructural optical element, which controls distribution of light radiated from the LED chip. In this configuration, because the window cover is provided with a microstructural optical element, which controls distribution of light radiated from the LED chip, the distribution of light can be controlled with only the package.

### BRIEF DESCRIPTION OF THE DRAWINGS

Preferred embodiments of the invention will now be described in further details. Other features and advantages of the present invention will become better understood with regard to the following detailed description and accompanying drawings where:
Figs. 1A and 1B show an Embodiment 1 of the present invention, and Fig. 1A is a perspective view, and Fig. 1B is an exploded perspective view;
Fig. 2 is a cross-section view of Fig. 1A along a line X-X; and
Figs. 3A and 3B show an Embodiment 2 of the present invention, and Fig. 3A is a perspective view, and Fig. 3B is an exploded perspective view.

### BEST MODE FOR CARRYING OUT THE INVENTION

### (Embodiment 1)

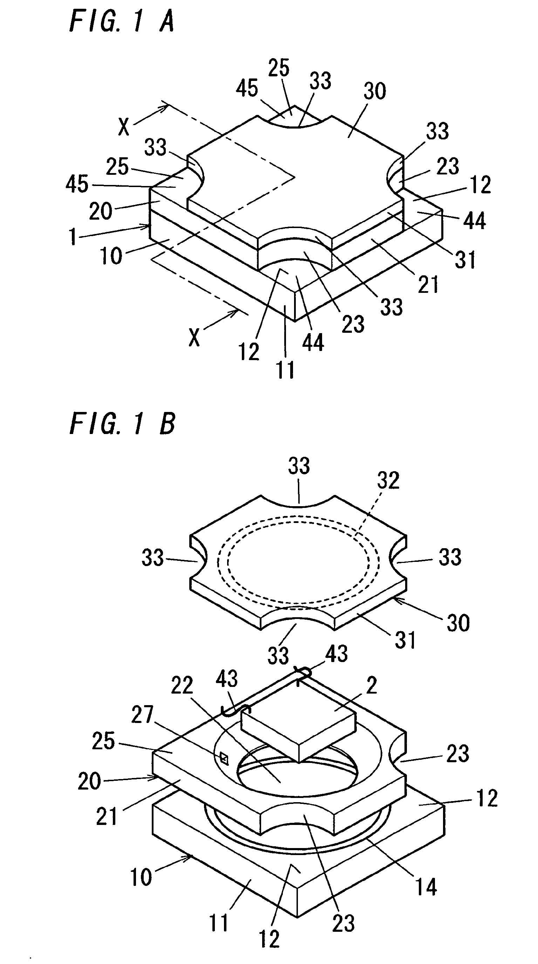

As shown in Figs. 1A and 1B, a light emitting diode of the present embodiment comprises a light emitting diode chip (LED chip) 2 having high brightness, a package 1 in which the LED chip 2 is housed, and first and second connection electrodes 44, 45. The package 1 is a three-layered laminated body comprising a submount substrate 10, a frame body 20 and a window cover 30. The package 1 is formed into a rectangular shape (a square shape in figures) as viewed from the front (as viewed from the light irradiation direction, that is, as viewed from an upper side in Fig 1A). The package 1 has a configuration explained below, and thereby can be formed into equal to or less than 3 mm-square as viewed from the front, and thickness thereof can be set to be about 1 mm.

The frame body 20 is provided with a storage hole 22 as a through-hole penetrated in the front and back direction. The window cover 30 is laminated on the submount substrate 10 via the frame body 20, and then the submount substrate 10, the frame body 20 and the window cover 30 are secured together, and thereby the storage hole 22 is sealed hermetically. That is, the storage hole 22 is surrounded by the submount substrate 10, the frame body 20 and the window cover 30, and thereby an air proof space is formed.

The LED chip 2 is secured on the submount substrate 10 and is housed in the storage hole 22, and thereby, is housed in the air proof space. Then, the air proof space is not only sealed but also may enclose inert gas or may be depressurized to come into near-vacuum. That is, the LED chip 2 can be protected without potting a synthetic resin and it becomes easy to ensure efficiency of light irradiation.

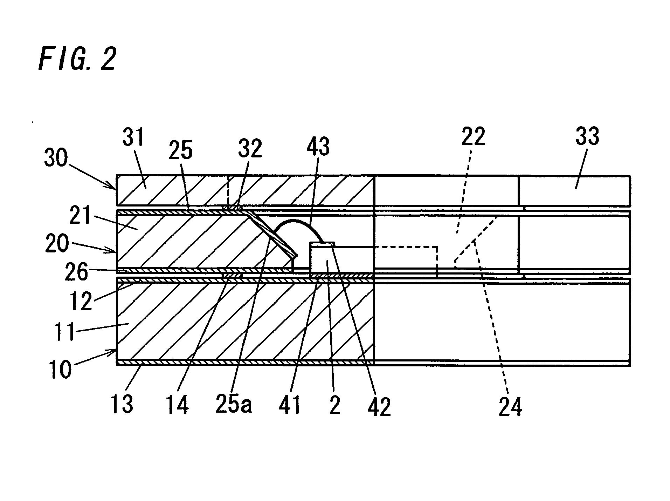

The submount substrate 10 comprises bonding layers 12, 13 and a base material 11, which is formed by using an insulating material into a rectangular shape as viewed from the front. The bonding layers 12, 13 are formed of conductive metallic thin films, and are located on both end faces in a thickness direction of the base material 11, respectively, as shown in Fig. 2. Further, as shown in Figs. 1B and 2, the base material 11 is provided on its one surface with a bonding layer 14 formed into a circular ring. In addition, the one surface of the base material 11 is one end face of both end faces in its thickness direction, which faces the frame body 20. That is, it is one end face facing toward the light irradiation direction.

The base material 11 has about the same linear expansion coefficient as the LED chip 2, and is made of an insulating material having a relatively high heat conductivity. Materials meeting such a condition are AlN (Aluminum Nitride), SiC (Silicon Carbide) and diamonds. However, it is desirable to adopt AIN from a cost-effectiveness standpoint. Then, for example, the bonding layers 12, 13 are made of Au and the bonding layer 14 is made of AuSn. The bonding layers 12, 13 are formed in the front and back of the base material 11, respectively, and are electrically insulated from each other.

As shown in Figs. 1 and 2, the frame body 20 comprises a base material 21 formed by using an insulating material into a rectangular shape as viewed from the front. The base material 21 is provided in its central part with the storage hole 22, which opens with a circular shape. Then, as shown in Figs. 1A and 1B, fan-shape notches as viewed from the front are put in adjacent two corner portions of four corner portions in the base material 21, and thereby two first electrode windows 23 are formed. An inner periphery face of the storage hole 22 has an inclined surface 24, which is formed into a tapered shape so that an inner diameter thereof gradually increases toward the light irradiation direction from the submount substrate 10.

As shown in Fig. 2, the base material 21 is provided on both end faces in its thickness direction with bonding layers 25, 26, which are formed of conductive metallic thin films, respectively. Then, the bonding layer 26 is formed on one end face of said both end faces, facing the submount substrate 10 (that is, one end face facing toward the direction opposite to the light irradiation direction), into a circular ring so as to be bonded to the bonding layer 14 in the submount substrate 10. However, the shape of the bonding layer 26 is not limited to the circular ring, and the bonding layer 26 may be formed over a whole surface of said one end face. Then, the bonding layer 25 is formed on the other end face of said both end faces, facing the window cover 30 (that is, the other end face facing toward the light irradiation direction), and continues into a connecting pattern 25a formed on the inner periphery face of the storage hole 22. That is, the connecting pattern 25a is made of the same material as the bonding layer 25, and has conductive properties.

The base material 21 is made of the insulating material having heat resistance. However, the material of the base material 21 is not limited, as long as a there is little difference between linear expansion coefficients of the base material 21 and the submount substrate 10. Then, for example, Al₂O₃ can be selected as the material of the base material 21. The bonding layer 26 is made of, for example, Au to be hermetically bonded to the bonding layer 14. Then, the bonding layer 25 is also made of, for example, Au. However, the bonding layers 25, 26 in the front and back of the frame body 20 are electrically insulated from each other.

As shown in Figs. 1 and 2, the window cover 30 comprises a base material 31, which is transparent to a wave length of light radiated from the LED chip 2. As shown in Figs. 1B and 2, the base material 31 is provided on its one surface facing the frame body 20 with a bonding layer 32, surrounding the storage hole 22, formed into a circular ring. Then, fan-shape notches as viewed from the front are put in all four corner portions in the base material 31, and thereby four second electrode windows 33 are formed.

If a luminous wavelength of the LED chip 2 is within a wavelength region (300 to 2500 nm) from a near-ultraviolet region to a far-infrared region, a borosilicate crown glass (BK7), which is an optical glass, is used for the base material 31. Then, if the luminous wavelength is shorter than the near-ultraviolet region, a quartz glass is used for the base material 31. Then, the bonding layer 32 is made of, for example, AuSn.

In the present embodiment, the submount substrate 10, frame body 20 and the window cover 30 are basically bonded together automatically by Au-AuSn bonding. That is, Au is used for the bonding layer 26 of the frame body 20 and AuSn is used for the bonding layer 14 of the submount substrate 10, and then the submount substrate 10 and the frame body 20 are bonded to each other by Au-AuSn bonding. Then, Au is used for the bonding layer 25 of the frame body 20 and AuSn is used for the boding layer 32 of the window cover 30, and then the frame body 20 and window cover 30 are bonded to each other by Au-AuSn bonding.

In the Au-AuSn bonding, after bonding parts are aligned each other, the bonding parts are heated to an appropriate temperature (for example, 280 degrees C). Then, AuSn is melt and thereby the bonding parts are bonded to each other. Here, the submount substrate 10 and the frame body 20 are not transparent to light. Therefore, when the submount substrate 10 and the frame body 20 are bonded to each other, these bonding parts are heated by using, for example, a heater (in this case, the bonding parts are heated before mounting the LED chip 2). On the other hand, the window cover 30 is transparent to light. Therefore, when the frame body 20 and the window cover 30 are bonded to each other, these bonding parts are heated by using, for example, a laser beam.

An ultraviolet light emitting diode, made of materials of GaN system, can be used for the LED chip 2 other than the infrared region and the visible region. Then, the LED chip 2 is provided on both end faces in its thickness direction with element electrodes 41, 42, respectively. Specifically, as shown in Fig. 2, the LED chip 2 is provided on one end face of the both end faces with an anode (element electrode 41), and is provided on the other end face of the both end faces with two cathodes (element electrode 42). If the LED chip 2 irradiates ultraviolet and the package is made of a synthetic resin, the package easily deteriorates. On the other hand, the package 1 of the present embodiment is made of an inorganic material. Therefore, the deterioration due to the ultraviolet is inhibited and the light emitting diode can have a longer life. Then, the LED chip 2 is sealed in the air proof space, and the potting is not used. Thus, just like use of the inorganic material, the deterioration due to the ultraviolet is inhibited and the light emitting diode can have a longer life.

The LED chip 2 is installed fixedly on the submount substrate 10 and die bonding is performed, when mounted in the package 1. The anode (element electrode 41) of the LED chip 2 is bonded to the bonding layer 12 of the submount substrate 10 upon the die bonding.

On the other hand, the two cathodes (element electrode 42) of the LED chip 2 are electrically connected to the connecting pattern 25a formed on the inner periphery face of the storage hole 22 via wires 43 for wire bonding. Then, as shown in Fig. 1B, it is desirable that bonding recesses 27 are formed in two places of the inclined surface 24 and one ends of the wires 43 are bonded to the bonding recesses 27, respectively. Each of the bonding recesses 27 is provided in its inner periphery face with a pedestal surface (not shown), which is formed in parallel to one surface of the frame body 20 facing the submount substrate 10. Then, the wires 43 are bonded to the pedestal surfaces of the bonding recesses 27, respectively. The connecting pattern 25a is formed so as to extend onto the pedestal surfaces.

That is, when the LED chip 2 is mounted on the submount substrate 10 by the die bonding and the frame body 20 is bonded to the submount substrate 10, both ends of each wire 43 can be bonded to the LED chip 2 and the frame body 20 with the force acting in the same direction, respectively. As a result, good workability can be ensured in assembling.

Then, the inclined surface 24 of the storage hole 22 is formed so that an inner diameter thereof gradually increases toward the light irradiation direction. Thereby, when bonding the two cathodes (element electrode 42) of the LED chip 2 to the connecting pattern 25a through the wires 43, a working space for the wire bonding can be ensured relatively widely. Thus, good workability can be ensured.

Furthermore, the inclined surface 24 is covered with the connecting pattern 25a made of metal, and thereby light radiated from a periphery of the LED chip 2 is reflected by the inclined surface 24 and is radiated toward the window cover 30. That is, in addition to light radiated from one end face facing the window cover 30, light radiated from the periphery is also radiated toward the window cover 30.

The window cover 30 may be provided in at least one end face of both end faces in its thickness direction with a optical element, which comprises a microstructural convexconcave formed into a groove, a cone, a dome, etc. Here, the optical element is located in at least a region facing the storage hole 22 in at least one end face of said both end faces. That is, the window cover 30 comprises a lot of micro lenses, micro prisms, gratings, etc. as the optical element, and thereby distribution of light from the LED chip 2 may be controlled.

As described above, the window cover 30 is provided with the four second electrode windows 33 in four corner portions. The frame body 20 is provided with the two first electrode windows 23 in adjacent two corner portions of four corner portions. Then, the bonding layer 25 is formed in one end face of both end faces in the thickness direction of the frame body 20, facing the window cover 30. Then, the bonding layer 25 is partly exposed on the outside of the package 1. At this time, as shown in Fig. 1A, the bonding layer 25 is partly exposed in the light irradiation direction through two second electrode windows 33 of the window cover 30. Furthermore, the bonding layer 25 is electrically connected to the LED chip 2 in the inner periphery face of the storage hole 22. As a result, parts of the bonding layer 25, exposed through the second electrode windows 33, function as the second connection electrodes 45 electrically connected to the element electrodes 42, which are the two cathodes of the LED chip 2.

The remaining two second electrode windows 33 of the window cover 30 coincide with the two first electrode windows 23 of the frame body 20, respectively. The bonding layer 12 is formed on one end face of both end faces in a thickness direction of the submount substrate 10, facing the frame body 20. Then, the bonding layer 12 is partly exposed on the outside of the package 1. At this time, as shown in Fig. 1A, the bonding layer 12 is partly exposed in the light irradiation direction through the remaining two second electrode windows 33 of the window cover 30 and the two first electrode windows 23 of the frame body 20. The bonding layer 12 is bonded to the element electrode 41, which is the anode of the LED chip 2, by the die bonding. As a result, parts of the bonding layer 12, exposed through the two first electrode windows 23, function as the first connection electrodes 44 electrically connected to the element electrode 41, which is the anode of the LED chip 2.

As explained above, the LED chip 2 is sealed and airproofed in the package 1, and the first and second connection electrodes 44, 45 are exposed in the light irradiation direction in the package 1. Then, the bonding layer 13 is formed on the other end face of both end faces in the thickness direction of the submount substrate 10, facing toward a direction opposite to the light irradiation direction. Therefore, the bonding layer 13 is bonded to a heat dissipation member (not shown) made of metal, such as Cu or Al, and thereby a path for heat dissipation can be ensured.

Here, in order to improve airtightness of bonding parts of the submount substrate 10, the frame body 20 and the window cover 30 constituting the package 1, these mutually-bonded members are required to have flat and smooth surfaces. In the present embodiment, materials, such as AlN, Al₂O₃ and BK7, used for base materials of these bonded members, meet the above-mentioned requirement, and thus high airtightness can be ensured.

In addition, the submount substrate 10 and the frame body 20 of the present embodiment are formed of individual members differing from each other, respectively. However, for example, these may be integrally formed of one common member. In this regard, it is easier to polish surfaces in a case where the storage hole 22 is penetrated in a platy member like the present embodiment than in a case where a recess corresponding to the storage hole 22 is previously formed in the one common member. Thus, flat and smooth surfaces can be ensured easily.

The bonding layer 13 and the heat dissipation member of the package 1 are bonded to each other by using a bonding material, such as a slack wax (for example, a solder), a metal paste (for example, a silver paste), etc. which is liquid upon bonding and becomes hardened after bonding. The bonding can be performed so as not to form an air space between one face of the package 1 and the heat dissipation member by using such a bonding material. In addition, such a bonding material has a relatively high heat conductivity, and then can conduct heat from generally a whole area of the one face of the package 1 to the heat dissipation member. Thus, efficiency of heat dissipation can be improved.

Here, the bonding layer 13 and the LED chip 2 are electrically insulated from each other. Therefore, the bonding material having a high heat conductivity (typically, this kind of bonding material also has a high electrical conductivity) can be used without electrically insulating the heat dissipation member from the package 1. Thus the bonding material can improve heat conduction from the package 1 to the heat dissipation member.

Then, the first and second connection electrodes 44, 45 are located within a projection plane when the package 1 is viewed from the light irradiation direction. Thus, a plurality of packages 1 can be arranged without space between adjacent packages 1, when being mounted on the heat dissipation member. That is, the density of LED placement can be improved, and a light source having high brightness can be provided.

In addition, the first and second connection electrodes 44, 45 are exposed on the front, and each of the first and second connection electrodes 44, 45 comprises two electrodes having the same polarity each other. Thus, if angles of a plurality of packages 1 are adjusted in being arranged, it becomes easy to identify polarity of the electrode. Thus, it becomes easy to perform connection work to electrically connect the plurality of packages 1 together. In electrically connecting the plurality of packages 1, there are available various technologies, such as wire bonding technology with Au-wire or Al-wire, solder bonding technology with connecting wire, pressed contact technology to elastically connect a connecting conductor secured in the heat dissipation member with the first and second connection electrodes 44, 45, etc. In addition, the plurality of packages 1 can be connected to a power source individually, and then can be connected in series or in parallel.

By the way, the package 1 is made of an inorganic material and the heat dissipation member is made of metal. Thus, there is a relatively-large difference between linear expansion coefficients of the package 1 and the heat dissipation member. However, the package 1 is bonded to the heat dissipation member through a whole surface of its one side, and then a bonding surface of the package 1 is formed into equal to or less than 3 mm-square. Therefore, the bonding intensity and the strength of the package 1 can be increased sufficiently with respect to a stress depending on the difference between the linear expansion coefficients. As a result, such a configuration can prevent a bonding part from coming unglued, and can prevent the package 1 from being damaged.

### (Embodiment 2)

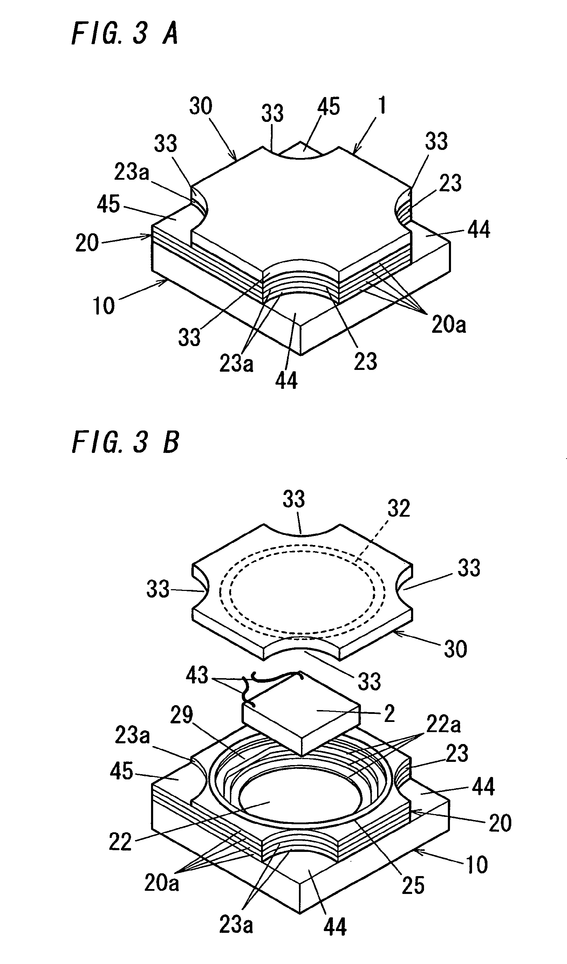

As shown in Figs. 3A and 3B, the frame body 20 of the present embodiment is formed by lamination of a plurality of sheeted frame boards 20a (four frame boards is shown in figures). Each frame board 20a is provided in its central part with a hole 22a penetrated in the front and back direction. Then, the storage hole 22 is formed by superposition of a plurality holes 22a associated with lamination of the plurality of frame boards 20a. Each frame board 20a that doesn't include one frame board 20a has the hole 22a penetrated into a circular-shape. On the other hand, said one frame board 20a has the hole 22a penetrated into generally a D-shape, like a circle cut off by a chord, as shown in Fig. 3B.

Furthermore, the plurality of holes 22a have a different diameter. A frame board 20a laminated directly on the submount substrate 10 is provided with the hole 22a having the smallest diameter, and then the remaining frame boards 20a are laminated so that diameters of the holes 22a increase in sequence. Therefore, the inner periphery face of the storage hole 22 is formed into not a tapered shape but a stepped shape, and then a diameter thereof gradually increases toward the window cover 30 from the submount substrate 10. Then, as shown in Fig. 3B, the D-shaped frame board 20a comprises a connection piece 29 partly projecting from the inner periphery face of the storage hole 22.

Each of the plurality of frame boards 20a is provided on both end faces in its thickness direction with bonding layers (not shown) of metallic thin films, respectively. Then, adjacent frame boards 20a are bonded to each other through the bonding layers, and thereby the plurality of frame boards 20a are bonded together and sealed hermetically. Then, in these bonding layers, the metallic thin films (for example, Au) having high electrical conductivity are used for at least bonding layers formed in the frame board 20a comprising the connection piece 29. That is, a connecting pattern (not shown) continuing into the bonding layer is formed on the connection piece 29. In addition, as shown in Fig. 3B, the frame board 20a comprising the connection piece 29 is located next to the frame board 20a contacting with the window cover 30.

By the way, an outer periphery of the frame board 20a touching the window cover 30 has the same size and the same shape as that of the window cover 30. That is, this frame board 20a has the first electrode windows 23a in all of four corner portions like the window cover 30. On the other hand, subsequent frame boards 20a have the first electrode windows 23a in only adjacent two corner portions of four corner portions like the frame body 20 of the Embodiment 1. Therefore, the bonding layer formed in second top frame board 20a is partly exposed on the outside of the package 1 through the first electrode windows 23a of first top frame board 20a and the second electrode windows 33 of the window cover 30, and functions as the second connection electrode 45.

On the other hand, one end of each wire 43 is connected to the cathode (element electrode 42) of the LED chip 2, and the other of each wire 43 is bonded to the connection piece 29. That is, the second connection electrode 45 is electrically connected to the cathode (element electrode 42) of the LED chip 2. Then, the storage hole 22 is provided in its inner periphery face with the connection piece 29 projecting. Therefore, a site, to which one end of each wire 43 is bonded, can have a relatively-large area. Furthermore, a surface of the site, to which one end of each wire 43 is bonded, is parallel to a surface of the submount substrate 10, and thereby the one end of each wire 43 can be bonded to the site from the same direction. As a result, the bonding operation of wires 43 can be easily performed.

Then, because the second connection electrode 45 is located in second top frame board 20a of the frame body 20, the bonding layer 25 bonded to the window cover 30 should be formed into a circular ring in the frame body 20. Other configuration and function be no different from the Embodiment 1.

In addition, the above-mentioned material is cited as one example about each member. For example, Al can be used instead of Au, and AnAgCu can be used instead of AuSn. Then, a foundation layer may be formed in a site constituting the Au thin film in order to prevent saturation of the base material. Then, Ni/Cu (when the base material is Al₂O₃), Pt/Ti (when the base material is BK7), etc. can be used for the foundation layer in accordance with the base material. Then, the electrode window can be formed into a triangular-shape notch, a quadrangular-shape notch, etc. other than a fan-shape notch as described above.

basically, one LED chip 2 is housed in one package 1. However, a plurality of LED chips 2 may be housed in one package 1. Then, in the above configuration, the anode (element electrode 41) is bonded to the submount substrate 10. However, the anode may be replaced with the cathode.

Although the present invention has been described with reference to certain preferred embodiments, numerous modifications and variations can be made by those skilled in the art without departing from the true spirit and scope of this invention, namely claims.

## Claims

1. A light emitting diode comprising:
a LED chip;
a package in which the LED chip is housed; and
a connection electrode electrically connected to an element electrode with which the LED chip is provided,
wherein the package is a laminated body comprising at least a submount substrate and a frame body, the LED chip being fixedly-mounted on one surface of the submount substrate, the frame body being laminated on the one surface of the submount substrate and being provided with a through-hole in which the LED chip is stored,
wherein the connection electrode is formed on at least either the one surface of the submount substrate or one surface of the frame body facing toward a light irradiation direction, while being exposed in the light irradiation direction.

2. The light emitting diode as claimed in claim 1, wherein an inner periphery face of the through-hole is formed so that a diameter thereof gradually increases toward the light irradiation direction from the submount substrate,
wherein the through-hole is provided with a conductive connecting pattern electrically connected to the connection electrode on the inner periphery face,
wherein the connecting pattern is electrically connected to the element electrode of the LED chip.

3. The light emitting diode as claimed in claim 1 or 2, wherein the connection electrode comprises a first connection electrode and a second connection electrode, the first connection electrode being formed on the one surface of the submount substrate, the second connection electrode being formed on the one surface of the frame body facing toward the light irradiation direction,
wherein the first and second connection electrodes are electrically insulated from each other.

4. The light emitting diode as claimed in claim 3, wherein the package is formed into a rectangular shape as viewed from the light irradiation direction,
wherein the frame body is provided with a first electrode window, the first electrode window exposing the first connection electrode located in each of two corner portions on the one surface of the submount substrate,
wherein the frame body is provided with the second connection electrode in each of the remaining two corner portions.

5. The light emitting diode as claimed in claim 2, wherein the frame body is formed by lamination of a plurality of frame boards,
wherein one frame board of the plurality of frame boards comprises a connection piece projecting into the through-hole, the one frame board being something other than a frame board laminated at the outmost edge in the light irradiation direction,
wherein the connecting pattern is located on one surface of the connection piece facing toward the light irradiation direction.

6. The light emitting diode as claimed in claim 1, 2 or 5, wherein the package comprises a window cover, the window cover being laminated on the submount substrate via the frame body and being transparent to light radiated from the LED chip.

7. The light emitting diode as claimed in claim 6, wherein the submount substrate, the frame body, and the window cover are secured together so that an inside of the through-hole is airproofed.

8. The light emitting diode as claimed in claim 6, wherein the connection electrode comprises a first connection electrode and a second connection electrode, the first connection electrode being formed on the one surface of the submount substrate, the second connection electrode being formed on the one surface of the frame body facing toward the light irradiation direction,
wherein the first and second connection electrodes are electrically insulated from each other,
wherein the package is formed into a rectangular shape as viewed from the light irradiation direction,
wherein the frame body is provided with a first electrode window, the first electrode window exposing the first connection electrode located in each of two corner portions on the one surface of the submount substrate,
wherein the window cover is provided with a second electrode window, the second electrode window exposing the first electrode window and the second connection electrode located in each of the remaining two corner portions of the frame body.

9. The light emitting diode as claimed in claim 7, wherein the connection electrode comprises a first connection electrode and a second connection electrode, the first connection electrode being formed on the one surface of the submount substrate, the second connection electrode being formed on the one surface of the frame body facing toward the light irradiation direction,
wherein the first and second connection electrodes are electrically insulated from each other,
wherein the package is formed into a rectangular shape as viewed from the light irradiation direction,
wherein the frame body is provided with a first electrode window, the first electrode window exposing the first connection electrode located in each of two corner portions on the one surface of the submount substrate,
wherein the window cover is provided with a second electrode window, the second electrode window exposing the first electrode window and the second connection electrode located in each of the remaining two corner portions of the frame body.

10. The light emitting diode as claimed in claim 6, wherein the window cover is provided with a microstructural optical element, the microstructural optical element controlling distribution of light radiated from the LED chip.

11. The light emitting diode as claimed in any one of claims 7-9, wherein the window cover is provided with a microstructural optical element, the microstructural optical element controlling distribution of light radiated from the LED chip.
